(19) Europäisches Patentamt / European Patent Office / Office européen des brevets

(11) **EP 4 195 511 A1**

(12) **DEMANDE DE BREVET EUROPEEN**

(43) Date de publication:
**14.06.2023 Bulletin 2023/24**

(21) Numéro de dépôt: **22208256.2**

(22) Date de dépôt: **18.11.2022**

(51) Classification Internationale des Brevets (IPC):
**H03L 7/087** (2006.01)    **H03L 7/093** (2006.01)
**G01S 19/20** (2010.01)    **G01S 19/23** (2010.01)
**G06F 11/07** (2006.01)    **G06F 11/30** (2006.01)

(52) Classification Coopérative des Brevets (CPC):
**H03L 7/093; G01S 19/20; G01S 19/23;**
**G06F 11/0703; G06F 11/3058; H03L 7/087**

(84) Etats contractants désignés:
**AL AT BE BG CH CY CZ DE DK EE ES FI FR GB GR HR HU IE IS IT LI LT LU LV MC ME MK MT NL NO PL PT RO RS SE SI SK SM TR**
Etats d'extension désignés:
**BA**
Etats de validation désignés:
**KH MA MD TN**

(30) Priorité: **07.12.2021 FR 2113051**

(71) Demandeur: **Spectracom SAS**
**92310 Sevres (FR)**

(72) Inventeurs:
• **LORENTZ, Matthias**
  **78460 CHOISEL (FR)**
• **ECHELARD, Hervé**
  **91440 BURES SUR YVETTE (FR)**
• **BORGAGNI, Laurent**
  **92300 LEVALLOIS-PERRET (FR)**

(74) Mandataire: **Vidon Brevets & Stratégie**
**16B, rue de Jouanet**
**BP 90333**
**35703 Rennes Cedex 7 (FR)**

(54) **MODULE D´HORLOGE DE TRÈS GRANDE PRÉCISION ASSERVI PAR UN SIGNAL DE RÉFÉRENCE ET COMPRENANT UN SYSTÈME DE VÉRIFICATION D'INTÉGRITÉ DE PHASE**

(57) L'invention concerne un module d'horloge comprenant un oscillateur principal de précision générant un premier signal d'horloge de fréquence prédéterminée, un module récepteur d'une référence temporelle, fournie par exemple par un système de positionnement par satellites, apte à délivrer, lorsqu'il est actif, un signal de référence temporelle sur lequel est asservi l'oscillateur principal, et des moyens de détection d'une défaillance de l'oscillateur principal ou du signal de référence temporelle comprenant - un deuxième oscillateur d'un composant électronique du module d'horloge délivrant un deuxième signal d'horloge de fréquence prédéterminée, et - des moyens de traitement aptes à mesurer une pre-mière différence de phase ($x_{or}$) entre le premier signal d'horloge délivré par l'oscillateur principal et le signal de référence temporelle délivré par le module récepteur, une deuxième différence de phase ($x_{ho}$) entre le premier signal d'horloge délivré par l'oscillateur principal et le deuxième signal d'horloge délivré par le deuxième oscillateur, et une troisième différence de phase ($x_{hr}$) entre le signal de référence temporelle délivré par le module récepteur et le deuxième signal d'horloge délivré par le deuxième oscillateur, lesdits moyens de traitement étant aptes à calculer les dérivés du premier ordre des trois différences de phase mesurées de sorte à déterminer les variations respectives des trois différences de phase.

[Fig.1]

**Description**

**Domaine technique**

Le domaine de l'invention est celui des références de temps, en particulier celui des horloges de très haute précision.

Plus précisément, l'invention concerne un circuit/module d'horloge convenant comme référence de temps et de fréquence dans un équipement électronique numérique (un dispositif de radiolocalisation, par exemple).

**Art antérieur**

Un nombre croissant d'applications, par exemple la téléphonie mobile, la radiolocalisation, la diffusion numérique, les télécommunications sans fil, etc., reposent sur des références temporelles et/ou fréquentielles fiables. Les appareils utilisés dans ces applications intègrent des modules d'horloge à oscillateur, tel qu'un oscillateur de type à quartz thermostaté (OCXO) qui est un oscillateur de très hautes performances.

Ces oscillateurs très précis ne sont toutefois pas exempts de défauts.

Ainsi, la fréquence de tels oscillateurs est sujette à variations qui dépendent des conditions de fonctionnement de l'oscillateur, notamment les variations de température, l'usure et les vibrations auxquels est soumis l'oscillateur.

Pour compenser ces dérives et synchroniser ces appareils dans le domaine temporel, il est connu de mettre en œuvre dans les modules d'horloge un récepteur d'un système de positionnement par satellites apte à délivrer, lorsqu'il est actif, un signal de référence temporelle de sorte à asservir l'oscillateur interne/local de précision (OXCO par exemple) du module, dit oscillateur principal, avec un signal de référence fourni par l'horloge d'un système mondial de navigation par satellite GNSS (en anglais pour « Global Navigation Satellite System »), tel le système GPS, Galileo, GLONASS, BEIDU ou autre. On se sert donc du système GNSS (qui n'est pas non plus exempt de défaut ou de vulnérabilité du type brouillage) comme référence pour limiter cette dérive de l'horloge et de son oscillateur interne/local de précision.

Par ailleurs, des défaillances aléatoires (pannes) peuvent se produire sur l'oscillateur principal de l'appareil, comme sur tout composant électronique. Comme les horloges asservies sur une référence de temps comme le GNSS sont généralement utilisées pour synchroniser des infrastructures ou des systèmes critiques, elles doivent être conçues pour être fonctionnellement sûres et doivent toujours fonctionner de manière correcte et prévisible.

Pour remédier à ce problème, il est connu de mettre en œuvre deux oscillateurs du même type ou même trois. Cette redondance engendre toutefois des coûts supplémentaires.

Si le système compte sur le signal de référence temporelle, comme par exemple le GNSS, pour maintenir la précision et que le signal GNSS (GPS par exemple) tombe en panne en raison d'une perte de verrouillage, d'intempéries, de brouillage ou d'autres problèmes, ces modules d'horloge sont capables de maintenir le signal 1 PPS (impulsion par seconde) ou tout autre signal périodique délivré par l'oscillateur local de précision aligné avec un minimum de dérive jusqu'à ce que le verrouillage sur la référence de temps soit restauré.

Bien que les défaillances des références temporelles GNSS soient très rares, des problèmes graves ou des événements d'usurpation peuvent survenir.

En cas de problème d'intégrité (panne) du côté de la référence ou de l'oscillateur principal, une telle horloge doit rester sûre pour les utilisateurs, c'est-à-dire qu'elle doit continuer à fournir une heure stable et précise aux utilisateurs.

L'identification de l'origine d'une panne est particulièrement importante pour concevoir des horloges asservies sur une référence temporelle comme le GNSS qui sont tolérantes aux pannes. Si la défaillance est du côté de la référence GNSS, l'asservissement sur cette référence doit être immédiatement arrêté avant que l'effet de la défaillance ne se propage et l'horloge peut alors compter sur la stabilité de son oscillateur principal. Par contre, si la panne est du côté de l'oscillateur principal, les utilisateurs doivent être avertis que la maintenance ou le remplacement de l'oscillateur principal est nécessaire.

Lorsqu'on asservit un oscillateur principal comme un OCXO ou une horloge atomique sur une référence comme le GNSS, la différence de temps instantanée (ou différence de phase) entre les deux signaux délivrés par l'oscillateur principal et la référence de temps est la principale information de retour utilisée par le système de contrôle de l'oscillateur principal. La fiabilité de cette différence de phase tout au long du processus d'asservissement est donc cruciale. Dans des circonstances normales, des fluctuations de la différence de phase sont constatées avec des caractéristiques d'amplitude et de périodicité dépendant des bruits de la référence et de l'oscillateur principal. Cependant, un comportement anormal de la référence ou de l'oscillateur principal entraînerait des fluctuations ou des dérives de phase soudaines et non attendues. La question clé est alors de savoir si le problème se situe du côté de la référence, ou s'il s'agit d'un problème de stabilité ou de précision de l'oscillateur principal.

Il peut être parfois difficile d'identifier d'où vient le problème (soit du côté de l'oscillateur principal, soit du côté de la référence).

Pour résoudre cette problématique d'intégrité de la référence ou de l'oscillateur principal de précision, il a été proposé des solutions d'un niveau de complexité élevé, telles des couches logicielles qui font appel à l'analyse de messages du récepteur pour détecter des problèmes du système GNSS (GPS par exemple).

A l'heure actuelle, il n'existe aucun moyen simple de détecter les pannes

Un objectif de l'invention est donc de démêler une situation confuse (lorsqu'on ne sait pas d'où le problème vient) et le bon fonctionnement du mauvais, de façon simple et rapide.

Exposé de l'invention

L'invention répond à ce besoin en proposant un module d'horloge comprenant un oscillateur principal de précision dédié à la synchronisation et générant un premier signal d'horloge de fréquence prédéterminée, un module de réception d'une référence temporelle, fournie par exemple par un système de positionnement par satellites, apte à délivrer, lorsqu'il est actif, un signal de référence temporelle sur lequel est asservi l'oscillateur principal, et des moyens de détection d'une défaillance de l'oscillateur principal ou du signal de référence temporelle comprenant - un deuxième oscillateur non asservi d'un composant électronique du module d'horloge délivrant un deuxième signal d'horloge de fréquence prédéterminée relativement constante sur une courte période, et - des moyens de traitement aptes à mesurer une première différence de phase entre le premier signal d'horloge délivré par l'oscillateur principal et le signal de référence temporelle délivré par le module récepteur, une deuxième différence de phase entre le premier signal d'horloge délivré par l'oscillateur principal et le deuxième signal d'horloge délivré par le deuxième oscillateur, et une troisième différence de phase entre le signal de référence temporelle délivré par le module récepteur et le deuxième signal d'horloge délivré par le deuxième oscillateur, lesdits moyens de traitement étant aptes - à calculer les dérivées du premier ordre des trois différences de phase mesurées de sorte à déterminer les variations respectives des trois différences de phase, - à comparer les valeurs des dérivées du premier ordre calculées avec une valeur de seuil prédéterminée et - à détecter une défaillance de l'oscillateur principal lorsque les valeurs de la dérivée du premier ordre de la première différence de phase et de la deuxième différence de phase sont chacune supérieures à ladite valeur de seuil prédéterminée, ou une défaillance du signal de référence temporelle lorsque les valeurs de la dérivée de la première différence de phase et de la dérivée de la troisième différence de phase sont chacune supérieures à ladite valeur de seuil prédéterminée.

La solution de l'invention est mise en œuvre sur une horloge de très grande précision qui se sert d'un signal de référence, tel que celui reçu d'un système de positionnement par satellites GNSS par exemple, comme référence de temps externe sur lequel est asservi l'oscillateur de précision local de l'horloge, dit oscillateur principal. L'invention propose d'utiliser un oscillateur dit d'opportunité déjà présent dans un module d'horloge pour détecter des problématiques d'intégrité de l'oscillateur de précision du module d'horloge (oscillateur OXCO par exemple) ou du système de réception de la référence de temps (GNSS par exemple), sans surcoût et sans ajouter de composant. Presque chaque carte de circuit imprimé possède en effet au moins un oscillateur bon marché pour synchroniser un microprocesseur, les circuits FPGA ou bien les interfaces Ethernet, par exemple. L'oscillateur d'opportunité (qui fournit la fréquence d'un micro-processeur, tout micro-processeur ayant besoin d'un oscillateur) est utilisé comme signal de fréquence de référence relativement constante sur une courte période (mais peu précise et stable sur quelques minutes et heures).

Le second oscillateur dit d'opportunité est celui d'un composant électronique du module d'horloge qui n'a pas de contrainte de synchronisation à une référence, ni de besoin de haute stabilité en fréquence sur une longue période (mais dont la fréquence est relativement constante sur une courte période) pour détecter un comportement anormal de la référence ou de l'oscillateur principal de précision du module d'horloge.

Partant de ce principe, il est proposé, afin de détecter une défaillance et résoudre cette problématique d'intégrité de la référence ou de l'oscillateur principal, de mesurer plusieurs différences de phase, à savoir : - la différence de phase entre par exemple les deux signaux 1 PPS (impulsion par seconde) délivrés par l'oscillateur principal et la référence GNSS, - la différence de phase entre les deux signaux délivrés par l'oscillateur local et l'oscillateur d'opportunité du microprocesseur, et - la différence de phase entre les deux signaux délivrés par la référence GNSS par exemple et l'oscillateur d'opportunité du microprocesseur.

On calcule ensuite les dérivées premières de ces différences de phase ce qui revient à obtenir une variation en fréquence (en d'autres termes, la dérivée sert à déterminer les variations de la différence de phase), et si la valeur absolue de deux de ces dérivées est supérieure à un seuil prédéterminé, une alerte de maintenance est lancée (oscillateur de précision principal défaillant) ou on arrête d'asservir car on considère que la référence n'est plus valide (référence de temps défaillante). L'idée est de ne pas entraîner l'horloge et son oscillateur principal s'il y a un problème avec la référence et de ne pas laisser l'oscillateur principal de précision perturber la qualité du temps qu'il délivre sans le savoir et sans prévenir l'utilisateur.

Un comportement anormal de la référence ou de l'oscillateur principal de précision entraîne des fluctuations ou des dérives de phase soudaines et de tels problèmes potentiels d'intégrité de phase sont détectés en tirant parti d'un oscillateur tiers (dit d'opportunité) déjà présent dans le module d'horloge, comme l'horloge d'un microprocesseur intégré dans le module d'horloge. On utilise donc un autre oscillateur redondant pour déterminer si le problème se situe du côté de la référence ou du côté de l'oscillateur principal.

La solution de l'invention permet ainsi de désintriquer ou de démêler (« *disentangling* » en anglais) une situation confuse (dans laquelle il n'est pas clair si le problème vient de la référence ou de l'oscillateur principal) de façon simple et sans surcoût.

Il est à noter que l'horloge de très grande précision est asservie par un signal de référence qui n'est pas nécessairement un signal satellite de type GNSS mais qui peut être un signal de référence délivré par toute autre source de référence temporelle, telle que par une horloge de référence selon le protocole PTP (pour « *Precision Time Protocol* » en anglais), une horloge atomique locale ou autre.

Selon un aspect particulier de l'invention, lesdits moyens de traitement du module d'horloge sont en outre aptes à calculer les dérivés du second ordre des trois différences de phase mesurées et à détecter une défaillance de l'oscillateur principal lorsque la dérivée du second ordre de la troisième différence de phase est égale à 0 et les dérivées du second ordre des première et deuxième différences de phase sont non nulles, ou une défaillance du signal de référence temporelle lorsque la dérivée du second ordre de la deuxième différence de phase est égale à 0 et les dérivées du second ordre des première et troisième différences de phase sont non nulles. Les dérivées premières étant dépendante vis-à-vis de la constante de dérive de l'oscillateur d'opportunité qui n'est pas contrôlée ou mesurée a priori, on s'en affranchit en utilisant les dérivées secondes selon une mise en œuvre particulière de l'invention. Selon un aspect particulier de l'invention, les moyens de traitement sont configurés pour arrêter d'asservir l'oscillateur principal lorsqu'une défaillance du signal de référence temporelle est détectée et pour émettre une alerte lorsqu'une défaillance de l'oscillateur principal est détectée. Selon un aspect particulier de l'invention, le deuxième oscillateur du module d'horloge est celui d'un microprocesseur, d'un circuit intégré FPGA ou d'une interface Ethernet du module d'horloge. Selon un aspect particulier de l'invention, le module récepteur est apte à recevoir une référence temporelle délivrée par un système de positionnement par satellites de type GNSS, par une horloge de référence selon le protocole PTP ou par une horloge atomique locale. L'invention concerne également un procédé de détection d'une défaillance de l'oscillateur principal ou du signal de référence temporelle dans un module d'horloge tel que décrit précédemment comprenant un oscillateur principal de précision dédié à la synchronisation et générant un premier signal d'horloge de fréquence prédéterminée, un module récepteur d'une référence temporelle, fournie par exemple par un système de positionnement par satellites, apte à délivrer, lorsqu'il est actif, un signal de référence temporelle sur lequel est asservit l'oscillateur principal, des moyens de détection d'une défaillance de l'oscillateur principal ou du signal de référence temporelle comprenant un deuxième oscillateur non asservi d'un composant électronique du module d'horloge délivrant un deuxième signal d'horloge de fréquence prédéterminée relativement constante sur une courte période, et des moyens de traitement aptes à mettre en œuvre les étapes - de mesure d'une première différence de phase entre le premier signal d'horloge délivré par l'oscillateur principal et le signal de référence temporelle délivré par le module récepteur, d'une deuxième différence de phase entre le premier signal d'horloge délivré par l'oscillateur principal et le deuxième signal d'horloge délivré par le deuxième oscillateur, et d'une troisième différence de phase entre le signal de référence temporelle délivré par le module récepteur et le deuxième signal d'horloge délivré par le deuxième oscillateur, - de calcul des dérivés du premier ordre des trois différences de phase mesurées de sorte à déterminer les variations respectives des trois différences de phase, - de comparaison des valeurs des dérivés du premier ordre calculées avec une valeur de seuil prédéterminée et de détection d'une défaillance de l'oscillateur principal lorsque les valeurs de la dérivée du premier ordre de la première différence de phase et de la deuxième différence de phase sont chacune supérieures à ladite valeur de seuil prédéterminée, ou d'une défaillance du signal de référence temporelle lorsque les valeurs de la dérivée de la première différence de phase et de la troisième différence de phase sont chacune supérieures à ladite valeur de seuil prédéterminée. Selon un aspect particulier de l'invention, le premier signal d'horloge, le signal de référence temporelle et le deuxième signal d'horloge sont des signaux 1PPS, 10PPS ou 1PPM. L'invention concerne en outre un programme d'ordinateur comportant des instructions pour la mise en œuvre du procédé tel que décrit précédemment, lorsque le programme est exécuté par un processeur.

**Présentation des figures**

D'autres buts, caractéristiques et avantages de l'invention apparaîtront plus clairement à la lecture de la description suivante, donnée à titre de simple exemple illustratif, et non limitatif, en relation avec les figures, parmi lesquelles : parmi lesquelles :

[Fig 1] est une vue schématique d'un module d'horloge conforme à l'invention ;

[Fig 2] est un comparatif d'exactitude de fréquence sur une période de 60s de l'oscillateur de précision OCXO d'un module d'horloge conforme à l'invention et d'un autre oscillateur du module d'horloge, dit oscillateur d'opportunité, permettant la mise en œuvre de l'invention.

**Description détaillée d'un mode de réalisation de l'invention**

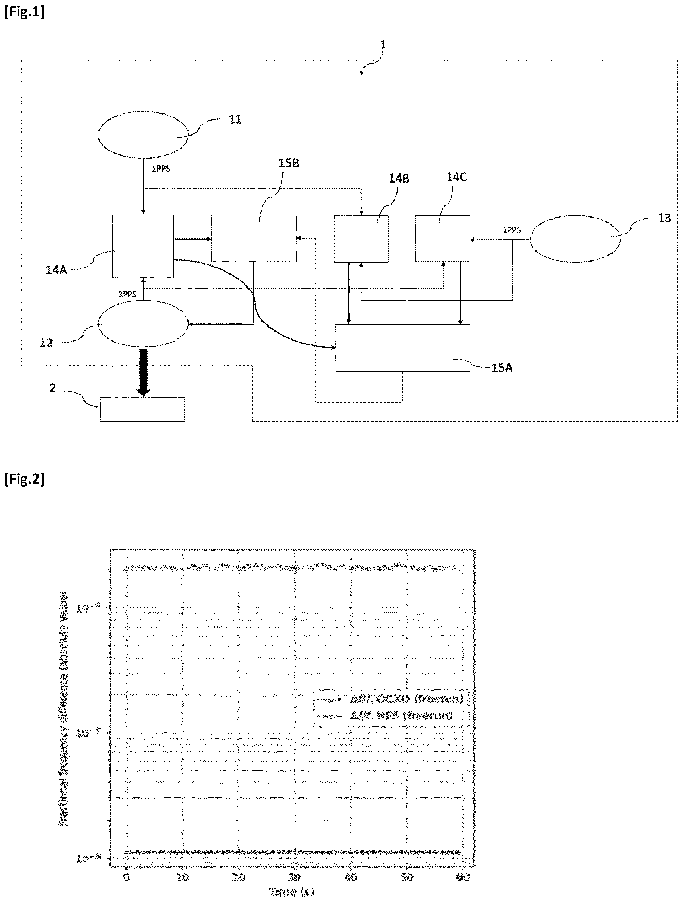

La figure 1 montre de façon schématique un module d'horloge 1 à oscillateur interne de précision 12, dit oscillateur principal ou oscillateur de précision ou oscillateur local, qui peut être un oscillateur de type à quartz thermostaté (oscillateur OCXO) ou une horloge atomique, générant un premier signal d'horloge de fréquence prédéterminée. Ce module d'horloge 1 est ici utilisé comme référence de temps et de fréquence dans un équipement électronique numérique 2 (un dispositif de radiolocalisation, par exemple).

Ce module d'horloge 1 comprend en outre un module récepteur 11 de fréquence GNSS apte à délivrer, lorsqu'il est actif, un signal de synchronisation par exemple 1PPS (impulsion par seconde) de référence temporelle qui est dérivé des informations de synchronisation transmises par les systèmes satellites GNSS (ou autres), sur lequel est asservit l'oscillateur principal 12.

Pour ce faire, le module d'horloge 1 met en œuvre un système de contrôle de l'oscillateur principal 12 comprenant un premier détecteur de phase 14A mesurant la différence de temps instantanée (ou différence de phase) entre les deux signaux 1PPS (ou autres) de l'oscillateur principal 12 et de la référence GNSS, et un algorithme logiciel 15B destiné à compenser les dérives de l'oscillateur principal 12.

Dans des circonstances normales, des fluctuations de la différence de phase sont observées et corrigées par le système de contrôle de l'oscillateur principal 12. Cependant, un comportement anormal de la référence ou de l'oscillateur principal entraînerait des fluctuations ou des dérives de phase soudaines et inattendues. La question clé est alors de savoir si le problème se situe du côté de la référence, ou s'il s'agit d'un problème de stabilité ou de précision de l'oscillateur principal. L'approche de l'invention consiste à tirer parti d'un oscillateur déjà présent dans le module d'horloge, comme l'horloge du microprocesseur par exemple. A titre d'exemple, dans la dernière génération d'horloges du déposant de la présente demande, le microprocesseur appelé HPS (pour « Hard Processor System » en anglais) est embarqué dans un circuit intégré FPGA. Le microprocesseur HPS est cadencé par un oscillateur MEMS, dit oscillateur d'opportunité par la suite, fournissant un signal de fréquence de 25 MHz à partir duquel il est possible de générer un signal 1PPS ou tout autre signal périodique. Bien évidemment, l'horloge d'un autre composant du module d'horloge peut être utilisée dans le cadre de l'invention.

Un tel oscillateur d'opportunité, bien qu'ayant un but initial différent et montrant des performances beaucoup plus faibles que l'oscillateur principal dédié à la synchronisation, est ici utilisé comme outil de comparaison pour l'ensemble oscillateur principal /système de référence. Pour ce faire, la solution de l'invention consiste à constamment surveiller la différence de phase ($x_{hr}$) entre le signal 1PPS généré par l'oscillateur d'opportunité (ici HPS) et le signal 1PPS généré par la référence, ainsi que la différence de phase ($x_{ho}$) entre le signal 1PPS par l'oscillateur d'opportunité (ici HPS) et le signal 1PPS généré par l'oscillateur principal, en plus de la différence de phase ($x_{or}$) entre le signal 1PPS généré par l'oscillateur principal et le signal 1PPS généré par la référence.

Les mesures de phase sont donc effectuées à partir des signaux 1PPS (on mesure la différence au niveau du front montant de chaque signal PPS) par trois détecteurs de phase, dits premier, deuxième et troisième détecteur de phase 14A, 14B et 14C, intégrés dans le circuit intégré FPGA susmentionné. Le deuxième détecteur de phase 14B mesure la différence de phase entre les deux signaux 1PPS de la référence et de l'oscillateur d'opportunité 13, le troisième détecteur de phase 14C mesurant la différence de phase entre les deux signaux de l'oscillateur principal 12 et de l'oscillateur d'opportunité 13.

En fonctionnement normal, la différence (ou la somme selon la convention de signe) $x_{ho}$ - $x_{hr}$ correspond à la différence de phase $x_{or}$ entre le signal 1PPS de l'oscillateur principal et le signal 1PPS de la référence. Un oscillateur d'opportunité comme l'oscillateur HPS n'est pas asservit. Par conséquent, les valeurs de $x_{hr}$ et $x_{ho}$ sont arbitraires et peuvent dériver rapidement car la précision de la fréquence d'un tel oscillateur d'opportunité est typiquement de l'ordre de $10^{-6}$ à $10^{-5}$. Cependant, sa dérive instantanée en fréquence est négligeable sur des périodes de courte durée (secondes à dizaines de secondes). Ce comportement est illustré sur la [Fig 2]. C'est cette hypothèse clé qui permet de démêler l'origine d'un problème de phase, l'oscillateur d'opportunité étant utilisé comme signal de fréquence de référence relativement constante.

La [Fig 2] est un comparatif d'exactitude de fréquence sur une période de 60s de l'oscillateur d'opportunité du microprocesseur HPS et de l'oscillateur principal de précision OCXO d'un module d'horloge utilisé lors de tests réalisés par le déposant.

La courbe du haut représente la fréquence relative (« *fractional frequency difference* » en anglais) de l'oscillateur d'opportunité du microprocesseur HPS sur une période de 60s.

La courbe du bas représente la fréquence relative de l'oscillateur de précision OCXO qui est l'oscillateur principal de l'horloge et qui est stable sur le court-terme. On voit qu'il y a plus de deux ordres de grandeur qui les séparent en exactitude, l'oscillateur d'opportunité étant moins exact (les deux étant relativement stables sur 60s). Même si la fréquence relative de l'oscillateur d'opportunité n'est pas exacte et dérive sur des intervalles de temps longs, elle peut être considérée comme constante sur des intervalles de temps courts comme visible sur la [Fig 2]. C'est ce point qui est utilisé pour mettre en œuvre la solution de l'invention.

Un comportement anormal de la référence ou de l'oscillateur principal entraine des fluctuations ou des dérives de phase soudaines. La question clé est alors de savoir si le problème se situe du côté de la référence, ou s'il s'agit d'un problème de stabilité ou de précision de l'oscillateur principal. Comme souligné précédemment, de tels problèmes potentiels d'intégrité de phase sont détectés en tirant parti d'un oscillateur tiers déjà présent dans le module d'horloge, comme l'horloge du microprocesseur. On utilise donc un autre oscillateur redondant pour déterminer si le problème se situe du côté de la référence ou du côté de l'oscillateur principal.

Les mesures de phase mentionnées précédemment sont effectuées au niveau d'un circuit FPGA et l'analyse de ces mesures est assurée par un algorithme 15A de la figure 1 dont les principales étapes sont les suivantes :

- on récupère les trois valeurs de phase à savoir la valeur de phase entre l'oscillateur principal et la référence, la valeur de phase entre l'oscillateur d'opportunité et l'oscillateur principal et la valeur de phase entre l'oscillateur d'opportunité et la référence ;
- on les stocke dans une table ;
- on calcule leurs dérivées premières selon une première approche, et leurs dérivées secondes également selon une deuxième approche, en termes de différences finies ce qui revient à estimer les différences de fréquence relative et leurs variations ;
- les valeurs absolue des dérivés première selon la première approche sont comparées à une valeur seuil prédéterminée, et lorsque cette valeur seuil est dépassée on lance une alerte (oscillateur principal défectueux) ou on arrête d'asservir l'oscillateur principal car on considère que la référence n'est plus valide.

Plus précisément, selon la première approche, les dérivées de phase successives (qui équivalent à la fréquence relative) sur une période d'échantillonnage $\tau$ sont calculées en termes de différences finies du premier ordre, comme suit :
[Math 1]

$$\dot{x}_{ho}(t) = \frac{x_{ho}(t) - x_{ho}(t-\tau)}{\tau} \simeq C_h - \Delta\dot{x}_o^{\text{ctrl}}(t) + w_{ho}(t), \tag{1}$$

$$\dot{x}_{hr}(t) = \frac{x_{hr}(t) - x_{hr}(t-\tau)}{\tau} \simeq C_h - \Delta\dot{x}_o^{\text{ctrl}}(t) + w_{hr}(t), \tag{2}$$

$$\dot{x}_{or}(t) = \frac{x_{or}(t) - x_{or}(t-\tau)}{\tau} \simeq -\Delta\dot{x}_o^{\text{ctrl}}(t) + w_{or}(t), \tag{3}$$

où w représente du bruit aléatoire, $C_h$ est l'erreur en fréquence relative de l'oscillateur d'opportunité (différence de fréquence fractionnaire) du microprocesseur HPS qui est considérée comme constante sur l'intervalle d'échantillonnage $\tau$, et $\Delta\dot{x}_0^{ctrl}(t)$ est la commande de fréquence appliquée sur l'oscillateur principal.

La variation en fréquence est supposée être constante. Un changement brutal de la valeur de la variation en fréquence indique un dysfonctionnement. Dans le cas d'un signal de référence défectueux, les dérivées $\dot{x}_{hr}$ et $\dot{x}_{or}$ sont impactés alors que la dérivée $\dot{x}_{ho}$ ne l'est pas. Dans le cas d'un signal de l'oscillateur principal défectueux, les dérivées $\dot{x}_{ho}$ et $\dot{x}_{or}$ sont impactés alors que la dérivée $\dot{x}_{hr}$ ne l'est pas. Ainsi, si les valeurs absolues des dérivées $\dot{x}_{hr}$ et $\dot{x}_{or}$ sont chacune supérieure à une valeur seuil prédéterminée et la valeur absolue de la dérivée $\dot{x}_{ho}$ est inférieure à ladite valeur seuil prédéterminée, alors il est déterminé que le signal de référence est défectueux et le mode de maintien (« *holdover mode* » en anglais) est enclenché. Si les valeurs absolues des dérivées $\dot{x}_{ho}$ et $\dot{x}_{or}$ sont chacune supérieure à une valeur seuil prédéterminée et la valeur absolue de la dérivée $\dot{x}_{hr}$ est inférieure à ladite valeur seuil prédéterminée, alors il est déterminé que l'oscillateur principal est probablement défectueux et un mode dégradé de synchronisation (« *disciplining degraded mode* » en anglais) est enclenché.

Si aucune de ces conditions n'est remplie mais qu'une différence de phase importante est calculée (c'est-à-dire que si la différence des dérivées $\dot{x}_{ho}$ et $\dot{x}_{hr}$ est non nulle à la résolution du bruit), il est détecté un problème et émis une alerte sans que la source du problème (référence ou oscillateur principal) puisse être identifiée.

Si aucun changement brutal des valeurs de la variation en fréquence n'est calculé, alors l'horloge principale continue d'être asservie par la référence (« *normal disciplining mode* » en anglais).

Ainsi, selon une première approche, l'observation de variations simultanées identiques sur deux dérivées de phase alors que la troisième dérivée de phase n'est pas impactée permet l'identification d'un problème d'intégrité.

Cependant, la constante de dérive de l'oscillateur d'opportunité étant inconnue et n'étant pas contrôlée par design, la mise en algorithme avec des seuils préalablement établie n'est pas absolument fiable.

Selon une deuxième approche, l'algorithme s'applique aux dérivées secondes des séries de phase (et donc équivalent à une dérive de fréquence relative) et non pas seulement aux dérivées premières des séries de phase (qui équivalent à la fréquence relative). Ainsi, afin donc d'éviter le calcul de $C_h$ et de fiabiliser davantage la détection d'un dysfonctionnement, la deuxième approche consiste à calculer les dérivés secondes des valeurs de phase (ou variation en fréquence) en termes de différences finies du second ordre comme suit :

[Math 2]

$$\ddot{x}_{ho}(t) = \frac{x_{ho}(t) - 2x_{ho}(t-\tau) + x_{ho}(t-2\tau)}{\tau^2} \simeq w'_{ho}(t),$$

$$\ddot{x}_{hr}(t) = \frac{x_{hr}(t) - 2x_{hr}(t-\tau) + x_{hr}(t-2\tau)}{\tau^2} \simeq w'_{hr}(t)$$

$$\ddot{x}_{or}(t) = \frac{x_{or}(t) - 2x_{or}(t-\tau) + x_{or}(t-2\tau)}{\tau^2} \simeq w'_{or}(t),$$

où $w'_{or}$, $w'_{hr}$ et $w'_{ho}$ sont des bruits aléatoires supposés être gaussiens et centrés sur 0.

Dans le cas d'un signal de référence défectueux, $\ddot{x}_{hr}$ et $\ddot{x}_{or}$ prendront une valeur non nulle alors que $\ddot{x}_{ho}$ conservera une valeur nulle à la résolution du bruit gaussien. Dans le cas d'un signal de l'oscillateur principal défectueux, $\ddot{x}_{ho}$ et $\ddot{x}_{or}$ prendront une valeur non nulle alors que $\ddot{x}_{hr}$ conservera une valeur nulle à la résolution du bruit gaussien. Les conditions de seuil précédemment décrites sont alors adaptées sans besoin d'estimer $C_h$, l'erreur en fréquence relative de l'oscillateur d'opportunité. L'analyse des dérivées secondes des phases avec conditions de seuil permet donc l'identification d'un problème d'intégrité de façon plus fiable que la première approche.

Le premier algorithme 15A reçoit et mémorise les trois différences de phase transmises par les premier, deuxième et troisième détecteurs de phase 14A, 14B et 14C respectivement et calcule leur dérivés première selon la première approche et leurs dérivés secondaires également selon la deuxième approche. Il met en œuvre également les étapes de traitement détaillées précédemment. Sur la base de ces données calculées, un deuxième algorithme 15B asservit l'oscillateur principal 12 par le biais d'instructions de contrôle et permet de compenser les dérives de l'oscillateur principal comme cela est connu dans l'art antérieur. Le système de vérification d'intégrité de phase comprend les trois détecteurs de phase, l'oscillateur d'opportunité et le premier algorithme 15A.

La solution de l'invention est sans surcoût et permet de détecter de façon réactive un problème (défaut de la référence ou de l'oscillateur principal). Elle nécessite de faire des comparaisons en construisant des différences de phase (c'est-à-dire des différences de temps) à partir de deux fréquences reçues. Toutes les secondes, on mesure l'intervalle de phase entre l'oscillateur principal et la référence. On fait de même entre l'oscillateur principal et l'oscillateur d'opportunité, et entre la référence et l'oscillateur d'opportunité. En analysant leurs évolutions à court terme, on peut déterminer s'il y a d'un côté ou de l'autre un problème d'intégrité.

La solution de l'invention améliore en outre la résistance aux fautes et au brouillage. Elle permet de détecter les problèmes d'intégrité (brouillage - ondes radio émises dans les fréquences GNSS qui dissimulent le signal GNSS ou empêchent sa bonne réception par le module d'horloge qui ne peut donner l'heure ou du moins qui délivre une heure imprécise). La précision du temps donné par GNSS a tendance à se relâcher en cas de brouillage jusqu'à ce que le récepteur (GPS par exemple) ne donne plus l'heure. Comme cette séquence peut être assez longue avant que cela arrive, on continue à utiliser cette heure imprécise et on nuit à la précision de l'horloge (puisque la référence devient imprécise). La solution permet de se passer de la référence en cas de défaut de ce genre-là (il vaut mieux ne pas utiliser la référence que d'utiliser une référence imprécise ou fallacieuse).

L'invention peut mettre en œuvre toute comparaison de phase, pas seulement basée sur des signaux 1PPS. La mesure de phase peut être mise en œuvre pour des signaux 10PPS (10 impulsions par secondes), 1PPM (1 impulsion par minute) ou pour tout autre signal périodique.

**Revendications**

1. Module d'horloge (1) comprenant un oscillateur principal (12) de précision dédié à la synchronisation et générant un premier signal d'horloge de fréquence prédéterminée, un module récepteur (11) d'une référence temporelle, fournie par exemple par un système de positionnement par satellites, apte à délivrer, lorsqu'il est actif, un signal de référence temporelle sur lequel est asservi l'oscillateur principal (12), et des moyens de détection d'une défaillance de l'oscillateur principal (12) ou du signal de référence temporelle comprenant - un deuxième oscillateur (13) non asservi d'un composant électronique du module d'horloge (1) délivrant un deuxième signal d'horloge de fréquence prédéterminée relativement constante sur une courte période, et - des moyens de traitement aptes à mesurer une première différence de phase ($x_{or}$) entre le premier signal d'horloge délivré par l'oscillateur principal (12) et le signal de référence temporelle délivré par le module récepteur, une deuxième différence de phase ($x_{ho}$) entre le premier signal d'horloge délivré par l'oscillateur principal (12) et le deuxième signal d'horloge délivré par le deuxième oscillateur, et une troisième différence de phase ($x_{hr}$) entre le signal de référence temporelle délivré par le module récepteur et le deuxième signal d'horloge délivré par le deuxième oscillateur (13), lesdits moyens de traitement étant aptes à calculer les dérivés du premier ordre des trois différences de phase mesurées de sorte à déterminer les variations respectives des trois différences de phase, à comparer les valeurs des dérivés du premier ordre calculées avec une valeur de seuil prédéterminée et à détecter une défaillance de l'oscillateur principal (12) lorsque les valeurs de la dérivée du premier ordre de la première différence de phase ($x_{or}$) et de la deuxième différence de phase ($x_{ho}$) sont chacune supérieures à ladite valeur de seuil prédéterminée, ou une défaillance du signal de référence temporelle lorsque les valeurs de la dérivée de la première différence de phase ($x_{or}$) et de la troisième différence de phase ($x_{hr}$) sont chacune supérieures à ladite valeur de seuil prédéterminée.

2. Module d'horloge selon la revendication 1, dans lequel lesdits moyens de traitement sont en outre aptes à calculer les dérivés du second ordre des trois différences de phase mesurées et à détecter une défaillance de l'oscillateur principal lorsque la dérivée du second ordre de la troisième différence de phase ($x_{hr}$) est égale à 0 et les dérivées du second ordre des première et deuxième différences de phase ($x_{or}$ $x_{ho}$) sont non nulles, ou une défaillance du signal de référence temporelle lorsque la dérivée du second ordre de la deuxième différence de phase ($x_{ho}$) est égale à 0 et les dérivées du second ordre des première et troisième différences de phase ($x_{or}$ $x_{hr}$) sont non nulles.

3. Module d'horloge selon la revendication 1 ou 2, dans lequel les moyens de traitement sont configurés pour arrêter d'asservir l'oscillateur principal lorsqu'une défaillance du signal de référence temporelle est détectée et pour émettre une alerte lorsqu'une défaillance de l'oscillateur principal est détectée.

4. Module d'horloge selon l'une des revendications 1 à 3, dans lequel le deuxième oscillateur est celui d'un microprocesseur, d'un circuit intégré FPGA ou d'une interface Ethernet du module d'horloge.

5. Module d'horloge selon l'une des revendications 1 à 4, dans lequel le module récepteur est apte à recevoir une référence temporelle délivrée par un système de positionnement par satellites de type GNSS, par une horloge de référence selon le protocole PTP ou par une horloge atomique locale.

6. Procédé de détection d'une défaillance de l'oscillateur principal ou du signal de référence temporelle dans un module d'horloge selon l'une des revendications 1 à 5 comprenant un oscillateur principal de précision dédié à la synchronisation et générant un premier signal d'horloge de fréquence prédéterminée, un module récepteur d'une référence temporelle, fournie par exemple par un système de positionnement par satellites, apte à délivrer, lorsqu'il est actif, un signal de référence temporelle sur lequel est asservi l'oscillateur principal, des moyens de détection d'une défaillance de l'oscillateur principal ou du signal de référence temporelle comprenant un deuxième oscillateur non asservi d'un composant électronique du module d'horloge délivrant un deuxième signal d'horloge de fréquence prédéterminée relativement constante sur une courte période, et des moyens de traitement aptes à mettre en œuvre les étapes - de mesure d'une première différence de phase ($x_{or}$) entre le premier signal d'horloge délivré par l'oscillateur principal et le signal de référence temporelle délivré par le module récepteur, d'une deuxième différence de phase ($x_{ho}$) entre le premier signal d'horloge délivré par l'oscillateur principal et le deuxième signal d'horloge délivré par le deuxième oscillateur, et d'une troisième différence de phase ($x_{hr}$) entre le signal de référence temporelle délivré par le module récepteur et le deuxième signal d'horloge délivré par le deuxième oscillateur, - de calcul des dérivés du premier ordre des trois différences de phase mesurées de sorte à déterminer les variations respectives des trois différences de phase, - de comparaison des valeurs des dérivés du premier ordre calculées avec une valeur de seuil prédéterminée et de détection d'une défaillance de l'oscillateur principal lorsque les valeurs de la dérivée du premier ordre de la première différence de phase ($x_{or}$) et de la deuxième différence de phase ($x_{ho}$) sont chacune supérieures à ladite valeur de seuil prédéterminée, ou d'une défaillance du signal de référence temporelle lorsque les valeurs de la dérivée de la première différence de phase ($x_{or}$) et de la troisième différence de phase ($x_{hr}$) sont chacune supérieures à ladite valeur de seuil prédéterminée.

7. Procédé selon la revendication 6, dans lequel le premier signal d'horloge, le signal de référence temporelle et le deuxième signal d'horloge sont des signaux 1PPS, 10PPS ou 1PPM.

8. Programme d'ordinateur comportant des instructions pour la mise en œuvre du procédé selon la revendication 6 ou 7, lorsque le programme est exécuté par un processeur.

[Fig.1]

[Fig.2]

Europäisches
Patentamt

European
Patent Office

Office européen
des brevets

# RAPPORT DE RECHERCHE EUROPEENNE

Numéro de la demande

**EP 22 20 8256**

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| X | EP 3 465 375 B1 (SCPTIME [FR]) 18 novembre 2020 (2020-11-18) * alinéa [0001] – alinéa [0080]; figures 1-6 * ----- | 1-8 | INV. H03L7/087 H03L7/093 G01S19/20 G01S19/23 |
| A | US 2016/352344 A1 (MAKI YOSHIYUKI [JP]) 1 décembre 2016 (2016-12-01) * alinéa [0003] – alinéa [0136]; figures 1-6 * ----- | 1-8 | G06F11/07 G06F11/30 |
| A | US 10 222 482 B2 (SEIKO EPSON CORP [JP]) 5 mars 2019 (2019-03-05) * colonnes 1-25; figures 1-16 * ----- | 1-8 | |

**DOMAINES TECHNIQUES RECHERCHES (IPC)**

H03L
G01S
G06F

Le présent rapport a été établi pour toutes les revendications

| Lieu de la recherche | Date d'achèvement de la recherche | Examinateur |
|---|---|---|
| La Haye | 31 janvier 2023 | Rafflenbeul, A |

EPO FORM 1503 03.82 (P04C02)

1

## ANNEXE AU RAPPORT DE RECHERCHE EUROPEENNE
## RELATIF A LA DEMANDE DE BREVET EUROPEEN NO.

EP 22 20 8256

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

31-01-2023

| Document brevet cité au rapport de recherche | | Date de publication | Membre(s) de la famille de brevet(s) | | Date de publication |
|---|---|---|---|---|---|
| EP 3465375 | B1 | 18-11-2020 | CN | 109791421 A | 21-05-2019 |
| | | | EP | 3465375 A1 | 10-04-2019 |
| | | | FR | 3051929 A1 | 01-12-2017 |
| | | | US | 2020125134 A1 | 23-04-2020 |
| | | | WO | 2017207932 A1 | 07-12-2017 |
| US 2016352344 | A1 | 01-12-2016 | CN | 106209078 A | 07-12-2016 |
| | | | JP | 6589375 B2 | 16-10-2019 |
| | | | JP | 2016225708 A | 28-12-2016 |
| | | | US | 2016352344 A1 | 01-12-2016 |
| | | | US | 2018234100 A1 | 16-08-2018 |
| US 10222482 | B2 | 05-03-2019 | AUCUN | | |

EPO FORM P0460

Pour tout renseignement concernant cette annexe : voir Journal Officiel de l'Office européen des brevets, No.12/82